# FASCICULE DE BREVET EUROPEEN

(11) **EP 3 588 104 B1**
(45) Date de publication et mention de la délivrance du brevet: **08.03.2023**
(21) Numéro de dépôt: 19183186.6
(22) Date de dépôt: 28.06.2019
(51) Int. Cl.: G01R 22/00

(54) **PROCÉDÉ DE DÉTECTION D'UNE DÉFAILLANCE DANS L'ALIMENTATION ÉLECTRIQUE D'UN VÉHICULE**
DETEKTIONSVERFAHREN EINER STÖRUNG IN DER STROMVERSORGUNG EINES FAHRZEUGS
METHOD FOR DETECTING A FAULT IN THE ELECTRIC POWER SUPPLY OF A VEHICLE

(30) Priorité: 29.06.2018 FR 1855929
(43) Date de publication de la demande: 01.01.2020
(73) Titulaire: ALSTOM Transport Technologies, 93400 Saint-Ouen (FR)
(72) Inventeur: MUSSET, Sébastien, 17220 SAINTE SOULLE (FR); DUBAN, Patrick, 17000 LA ROCHELLE (FR)
(74) Mandataire: Lavoix

(56) Documents cités:
- EP-A1- 2 994 332
- EP-B1- 2 994 332
- US-A1- 2017 124 783
- Krefeld: "eBus-High Power Charging Solutions from Siemens", , 20 avril 2015 (2015-04-20), page 4, XP055558820, Extrait de l'Internet: URL:https://w3.siemens.com/topics/global/d e/elektromobilitaet/PublishingImages/home/ pdf/siemens-presentation-ebus-en.pdf [extrait le 2019-02-19]

## Description

La présente invention concerne un procédé de détection d'une défaillance dans l'alimentation électrique d'un véhicule. L'invention concerne également un véhicule adapté pour mettre en oeuvre ce procédé.

On connaît des véhicules ferroviaires à traction électrique qui sont aptes à fonctionner aussi bien dans des zones pourvues d'une ligne d'alimentation électrique, telle qu'une caténaire ou un troisième rail, que dans des zones qui sont dépourvues d'une telle ligne d'alimentation électrique. Pour ce faire, ces véhicules ferroviaires comportent typiquement un dispositif de stockage d'énergie électrique, incluant des batteries d'accumulateurs ou des super-condensateurs. Le dispositif de stockage fournit au véhicule l'énergie électrique nécessaire pour fonctionner dans les zones dépourvues de ligne d'alimentation électrique. Ces véhicules ferroviaires comportent également un dispositif de collecte, tel qu'un pantographe ou un patin, pour collecter un courant électrique depuis la ligne d'alimentation électrique. Lorsque le véhicule est dans une zone pourvue d'une ligne d'alimentation électrique, le dispositif de collecte permet d'alimenter électriquement le véhicule et/ou de recharger le dispositif de stockage.

Cependant, il existe un risque que, notamment en cas de défaillance ou de mauvaise régulation du dispositif de stockage d'énergie, le dispositif de collecte soit traversé par un courant électrique qui dépasse les limites admissibles. Une telle situation peut se produire lorsque le dispositif de stockage d'énergie se décharge en injectant un courant électrique vers la ligne d'alimentation électrique au travers du dispositif de collecte alors que le véhicule ne se trouve pas dans un état permettant une telle décharge. Une telle situation peut également se produire lorsque le dispositif de stockage d'énergie se charge en captant un courant électrique depuis la ligne d'alimentation électrique au travers du dispositif de collecte alors que le véhicule ne se trouve pas dans un état permettant une telle charge.

Par exemple, le courant traversant le dispositif de collecte peut présenter une intensité trop élevée pendant une durée trop longue. Cela conduit généralement à un échauffement excessif du dispositif de collecte et/ou de la ligne d'alimentation électrique, qui peut conduire à une dégradation ou même une destruction du dispositif de collecte et/ou de la ligne d'alimentation électrique. Un état de la technique pertinent est divulgué dans le document US2017/124783.

C'est à ces inconvénients qu'entend plus particulièrement remédier l'invention en proposant un procédé de détection d'une défaillance dans l'alimentation électrique d'un véhicule.

Les caractéristiques essentielles de l'invention sont divulguées dans les revendications indépendantes 1 et 6. Les modes de réalisation de l'invention sont décrits dans les revendications dépendantes.

L'invention sera mieux comprise et d'autres avantages de celle-ci apparaîtront plus clairement à la lumière de la description qui va suivre d'un mode de réalisation d'un procédé de détection d'une défaillance dans l'alimentation électrique d'un véhicule ferroviaire donnée uniquement à titre d'exemple et faite en référence aux dessins annexés, dans lesquels :
- la figure 1 est un schéma synoptique d'un véhicule ferroviaire selon un mode de réalisation de l'invention ;
- la figure 2 est un ordinogramme d'un procédé de détection d'une défaillance dans l'alimentation électrique du véhicule ferroviaire, selon un mode de réalisation de l'invention ;
- les figures 3 et 4 sont des ordinogrammes illustrant des procédés complémentaires de détection d'une défaillance, selon des modes de réalisation additionnels de l'invention.

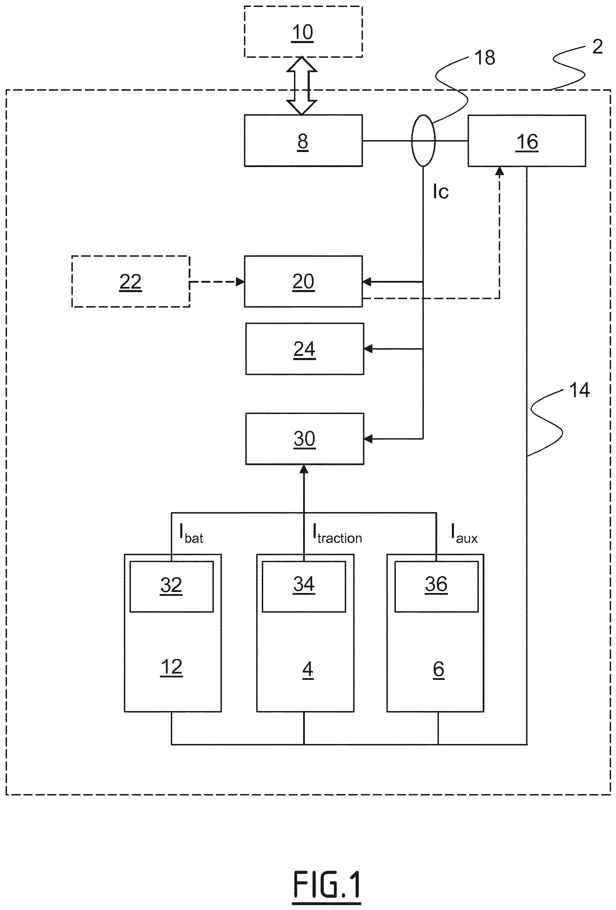

La figure 1 représente un véhicule 2 électrique comportant une chaîne de traction électrique 4, des équipements électriques auxiliaires 6, un dispositif de captage 8 pour collecter un courant électrique depuis une ligne d'alimentation extérieure 10 et un dispositif de stockage d'énergie 12.

Selon des modes de réalisation préférés, le véhicule 2 est un véhicule ferroviaire, et plus spécialement un véhicule de transport urbain, par exemple un tramway ou un métro ou un train de passagers. Selon d'autres variantes, le véhicule 2 est un véhicule routier électrique, tel qu'un trolleybus.

La chaîne de traction 4 comporte au moins un moteur électrique apte à mettre en mouvement le véhicule 2 lorsqu'il est alimenté électriquement.

Les équipements électriques auxiliaires 6 incluent par exemple un ou plusieurs d'un système d'éclairage, un système de signalisation ferroviaire, un système de climatisation et/ou de chauffage, ou encore un système d'information voyageurs. Tout ou partie de ces équipements auxiliaires 6 peuvent être omis.

Le dispositif de captage 8, aussi nommé dispositif de collecte, est adapté pour coopérer avec la ligne d'alimentation extérieure 10 afin d'alimenter électriquement le véhicule 2. Il est choisi en fonction de la technologie utilisée pour la ligne d'alimentation extérieure 10.

Selon des exemples, la ligne d'alimentation extérieure 10 comporte une caténaire, ou une ligne aérienne de contact, ou un rail électriquement conducteur tel qu'un troisième rail. Le dispositif de collecte 8 comporte alors, à titre d'exemple et selon les cas, un pantographe, ou une perche, ou un frotteur ou un patin.

Le dispositif de stockage 12 est apte à alimenter électriquement le véhicule 2, notamment pour alimenter la chaîne de traction 4, afin de faire circuler le véhicule 2 dans des zones dépourvues de ligne d'alimentation extérieure 10. Le dispositif de stockage 12 est rechargeable et peut stocker de l'énergie électrique collectée au moyen du dispositif de collecte 8.

Selon des modes de réalisation, le dispositif de stockage 12 comporte des batteries d'accumulateurs électrochimiques, par exemple de technologie lithium-ion ou nickel-cadmium ou nickel-hydrure métallique. Selon d'autres modes de réalisation, le dispositif de stockage 12 comporte des super-condensateurs ou supercapacités. Les éléments constitutifs du dispositif de stockage 12 peuvent être logés dans des coffres répartis à l'intérieur du véhicule 2.

Par exemple, le dispositif de stockage 12, la chaîne de traction 4 et les équipements auxiliaires 6 sont raccordés à un circuit de distribution électrique interne 14 connecté au dispositif de collecte 8. Le dispositif de collecte 8 est donc relié électriquement à la chaîne de traction 4 et au dispositif de stockage d'énergie 12.

De préférence, le véhicule 2 comporte un disjoncteur 16 connecté en sortie du dispositif de collecte 8. Lorsque le disjoncteur 16 est ouvert, il permet de déconnecter électriquement le dispositif de collecte 8 du circuit de distribution électrique interne 14, et donc de déconnecter électriquement le dispositif de collecte 8 du dispositif de stockage 12 et de la chaîne de traction 4.

On comprend que le véhicule 2 est apte à fonctionner aussi bien dans des zones pourvues d'une ligne d'alimentation extérieure 10 que dans des zones qui sont dépourvues d'une telle ligne d'alimentation extérieure 10.

En pratique, le véhicule 2 et notamment la chaîne de traction 4 peuvent être alimentés électriquement par le courant électrique collecté par le dispositif de collecte 8 depuis la ligne d'alimentation extérieure 10 ou par le dispositif de stockage d'énergie 12.

A titre d'exemple illustratif, le véhicule 2 peut fonctionner selon plusieurs modes d'alimentation :
- un mode dit autonome, dans lequel le véhicule 2 est alimenté par le dispositif de stockage 12 et dans lequel le dispositif de collecte 8 n'est pas utilisé ;
- un mode dans lequel le véhicule 2 est alimenté uniquement au moyen du dispositif de collecte 8 ;
- un mode mixte, dans lequel le véhicule 2 est alimenté à la fois par le dispositif de collecte 8 et par le dispositif de stockage 12 ;
- un mode de recharge, dans lequel le véhicule 2 est à l'arrêt et dans lequel le dispositif de stockage 12 est rechargé par le courant électrique collecté par le dispositif de collecte 8 depuis la ligne d'alimentation extérieure 10.

Par exemple, le véhicule 2 comporte un dispositif de régulation de l'alimentation électrique, non illustré, qui permet de sélectionner un mode d'alimentation en fonction de l'état de fonctionnement du véhicule 2.

L'état de fonctionnement du véhicule 2 est par exemple déterminé par une ou plusieurs des caractéristiques suivantes :
- le véhicule 2 est à l'arrêt ou en mouvement ;
- présence ou non de la ligne d'alimentation extérieure 10 dans la zone où se trouve le véhicule 2 ;
- le dispositif de collecte 8 est connecté ou déconnecté de la ligne d'alimentation extérieure 10 ;
- valeur ou niveau d'intensité de la force de contact, ou pression mécanique, entre le dispositif de collecte 8 et la ligne d'alimentation extérieure 10.

Le véhicule 2 comporte également un système de détection pour détecter une défaillance de l'alimentation électrique. De préférence, le système de détection comporte un capteur de courant 18 et une unité de commande électronique 20. Par exemple, l'unité de commande 20 est connectée au capteur de courant 18 et au disjoncteur 16.

Le capteur de courant 18 est apte à mesurer l'intensité d'un courant électrique le circulant au travers du dispositif de collecte 8. En pratique, le courant peut circuler dans un sens ou dans l'autre selon que du courant est prélevé par le véhicule 2 depuis la ligne d'alimentation extérieure 10 ou est injecté par le véhicule 2 vers la ligne d'alimentation extérieure 10. Par exemple, le capteur de courant 18 inclut un tore de Rogowski.

Dans l'exemple illustré, le capteur de courant 18 est placé en sortie du dispositif de collecte 8 et en amont du disjoncteur 16.

Selon des modes de mise en oeuvre, l'unité de commande 20 comporte une unité logique de calcul, telle qu'un microcontrôleur programmable ou un microprocesseur, et une mémoire informatique formant un support d'enregistrement de données lisible par ordinateur. Selon des exemples, la mémoire est une mémoire ROM, ou une mémoire RAM, ou une mémoire non volatile de type EPROM, ou EEPROM, ou FLASH, ou NVRAM, ou une mémoire optique ou magnétique ou à changement de phase. Dans la mémoire sont enregistrées des instructions exécutables pour mettre en oeuvre un procédé de détection d'une défaillance lorsque ces instructions sont exécutées par l'unité logique de calcul.

Selon d'autres modes de mise en oeuvre, l'unité de commande 20 comporte un composant logique programmable de type FPGA ou un circuit intégré dédié configuré pour mettre en oeuvre le procédé de détection.

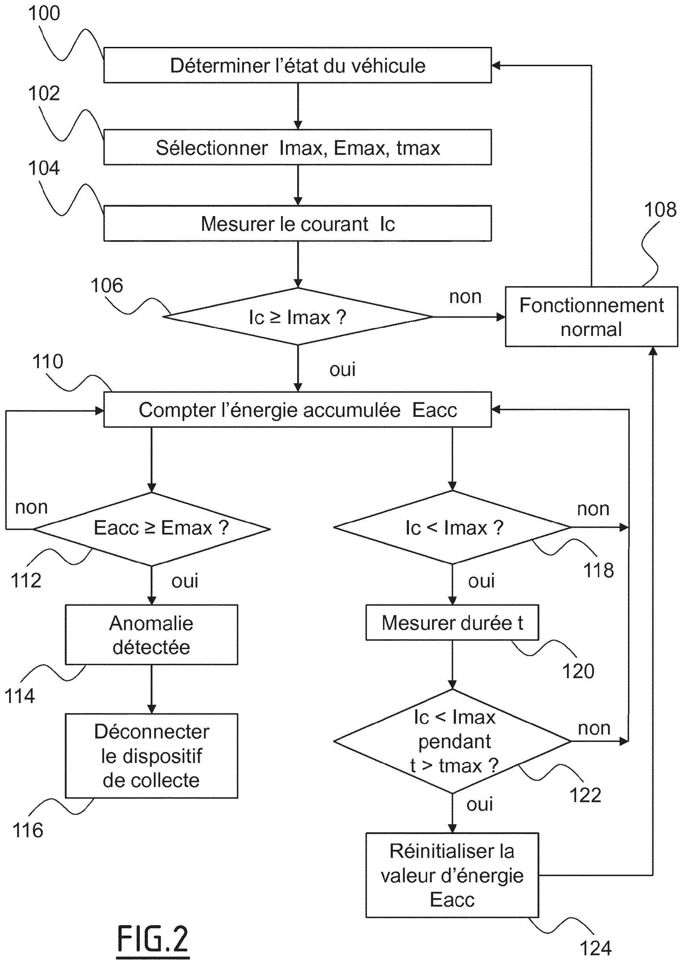

Un exemple de mise en oeuvre du procédé de détection d'une défaillance est maintenant décrit en référence à l'ordinogramme de la figure 2.

Initialement, et de façon optionnelle, lors d'une étape 100, un état de fonctionnement du véhicule 2 est détecté au moyen de l'unité de commande électronique 20, par exemple grâce à une interface 22 d'un ordinateur de bord du véhicule 2. Par exemple, une ou plusieurs des caractéristiques précédemment décrites comme représentatives de l'état de fonctionnement du véhicule 2 sont acquises.

Puis, lors d'une étape 102, elle aussi optionnelle, l'unité de commande 20 sélectionne automatiquement une première valeur prédéfinie d'un seuil de courant « Imax », une première valeur prédéfinie d'un seuil d'énergie « Emax » et, dans l'exemple illustré, une première valeur prédéfinie d'un seuil de durée « tmax ».

Les premières valeurs prédéfinies sont choisies parmi des valeurs prédéfinies préenregistrées en fonction de l'état de fonctionnement détecté lors de l'étape 100. Par exemple, les valeurs prédéfinies sont préalablement préenregistrées dans la mémoire de l'unité de commande par un constructeur ou un gestionnaire du véhicule 2.

Selon un exemple illustratif, lors de l'étape 100, la vitesse du véhicule 2 (à l'arrêt ou en déplacement) est déterminée et, lors de l'étape 102, les valeurs de seuil sont choisies en conséquence parmi les valeurs prédéfinies préenregistrées en sélectionnant des valeurs correspondant à la vitesse du véhicule 2.

En variante, la position du dispositif de collecte 8 et/ou la pression exercée par celui-ci sur la ligne d'alimentation extérieure 10 et/ou la position du véhicule électrique 2 le long de la voie, sont également déterminées lors de l'étape 100 et les valeurs de seuil sont choisies en conséquence parmi les valeurs prédéfinies préenregistrées en sélectionnant des valeurs correspondant à la vitesse du véhicule 2 et/ou à la position du dispositif de collecte 8 et/ou à la pression exercée par et/ou à la position du véhicule électrique le long de la voie.

Selon un exemple illustratif et non limitatif, pour un véhicule ferroviaire 2 de type tramway dont le dispositif de collecte 8 est connecté à une ligne d'alimentation extérieure 10 de type ligne aérienne de contact alimentée à 750 Volts continu, les premières valeurs seuil peuvent être choisies comme suit lorsque le véhicule 2 est à l'arrêt :
- premier seuil de courant Imax égal à 150 Ampères ;
- premier seuil d'énergie Emax égal à 542 Wh ;
- premier seuil de durée tmax égal à 10 secondes.

Toujours selon dans cet exemple illustratif et non limitatif, les premières valeurs seuil peuvent être choisies comme suit lorsque le véhicule 2 est en mouvement :
- premier seuil de courant Imax égal à 1600 Ampères ;
- premier seuil d'énergie Emax égal à 1875 Wh ;
- premier seuil de durée tmax égal à 10 secondes.

De façon générale, les premières valeurs de seuil Imax et Emax sont choisies en fonction des caractéristiques du dispositif de collecte 8 et de la ligne d'alimentation extérieure 10 et de l'interface entre ces derniers, et notamment de leur capacité à résister à une montée en température pendant une durée donnée.

En variante, les étapes 100 et 102 sont remplacées par une étape d'acquisition de valeurs seuil Imax, Emax, et tmax indépendamment de l'état du véhicule 2.

Lors d'une étape 104, l'intensité du courant électrique le circulant au travers du dispositif de collecte de courant 8 est mesurée au moyen du capteur de courant 18. Par exemple, le capteur de courant 18 mesure une valeur instantanée du courant Ic.

La mesure est de préférence répétée au cours du temps, par exemple avec une fréquence de mesure prédéfinie.

Lors d'une étape 106, l'unité de commande 20 compare automatiquement l'intensité le mesurée avec la première valeur seuil de courant Imax.

Si l'intensité mesurée Ic est inférieure à la première valeur seuil de courant Imax, alors l'unité de commande 20 considère à l'étape 108 que le fonctionnement de l'alimentation électrique du véhicule 2 est normal.

Au contraire, si l'intensité mesurée Ic est supérieure ou égale à la première valeur seuil de courant Imax, alors l'unité de commande 20 commence, lors d'une étape 110, à compter une valeur cumulée d'énergie électrique Eacc qui transite au travers du dispositif de collecte 8 au cours du temps.

Par exemple, la valeur d'énergie cumulée Eacc est comptée au moyen d'un compteur enregistré dans la mémoire de l'unité de commande 20 et qui est incrémenté au cours du temps en fonction des valeurs instantanées de courant le mesurées par le capteur 8. Le compteur peut être incrémenté ou décrémenté selon le sens de circulation du courant Ic.

Lors d'une étape 112, l'unité de commande 20 compare automatiquement la valeur cumulée Eacc avec la première valeur seuil d'énergie Emax. Par exemple, l'étape 112 est répétée au cours du temps, de préférence avec une périodicité prédéfinie.

Lorsque la valeur cumulée d'énergie Eacc devient supérieure ou égale à la valeur seuil d'énergie Emax alors l'unité de commande 20 considère, lors d'une étape 114, qu'une anomalie est détectée. L'unité de commande 20 ordonne alors, lors d'une étape 116, la déconnexion du dispositif de collecte 8.

La déconnexion peut être réalisée en déconnectant électriquement le dispositif de collecte 8 de la chaîne de traction 4 et du dispositif de stockage 12, par exemple en envoyant un signal de commande d'ouverture du disjoncteur 16. Alternativement et/ou conjointement, la déconnexion est réalisée en déconnectant électriquement le dispositif de collecte 8 de la ligne d'alimentation extérieure 10, par exemple en envoyant un signal de commande à un actionneur couplé au dispositif de collecte 8 pour déplacer le dispositif de collecte 8 afin de le désengager de la ligne d'alimentation extérieure 10.

En revanche, l'unité de commande 20 ne commande pas le dispositif de collecte 8 tant que la valeur cumulée d'énergie Eacc reste inférieure à la première valeur seuil d'énergie Emax.

Selon des modes de mise en oeuvre avantageux, en parallèle de l'étape 112, l'unité de commande 20 continue à comparer l'intensité mesurée le avec la valeur Imax, pour détecter si la valeur d'intensité mesurée le redevient inférieure à la valeur Imax pendant une durée t supérieure ou égale au seuil de durée tmax.

Dans l'exemple illustré, à l'étape 118, l'intensité mesurée le redevient inférieure à la valeur Imax. Lors d'une étape 120, l'unité de commande 20 commence à décompter une durée t et continue à comparer, à l'étape 122, l'intensité mesurée le avec la valeur Imax.

Si l'intensité mesurée le reste inférieure à la valeur Imax pendant une durée t supérieure ou égale au seuil de durée tmax, alors, lors d'une étape 124, l'unité de commande 20 réinitialise la valeur cumulée d'énergie Eacc. Dans le cas contraire, la valeur cumulée Eacc n'est pas réinitialisée. On entend par réinitialisation, une remise à zéro ou plus généralement une remise de la valeur cumulée d'énergie Eacc à une valeur initiale prédéterminée.

Grâce à l'invention, une défaillance de l'alimentation électrique du véhicule 2 peut être détectée et le dispositif de collecte 8 peut être déconnecté avant d'endommager la ligne d'alimentation extérieure 10 ou le dispositif de collecte 8.

Le procédé permet notamment de pallier au fait que les disjoncteurs généralement utilisés dans le véhicule 2 pour protéger le dispositif de collecte 8 ne permettent pas de sélectionner la courbe de déclenchement en fonction du mode d'alimentation électrique utilisé. De plus, ces disjoncteurs sont typiquement dimensionnés avec un calibre élevé de façon à autoriser la circulation d'un courant élevé lors de la recharge du dispositif de stockage 12 et ne peuvent donc pas détecter de façon satisfaisante une anomalie de fonctionnement susceptible d'endommager le dispositif de collecte 8 ou la ligne d'alimentation extérieure 10 qui se produirait à faible intensité sur une durée suffisamment longue.

La temporisation mise en oeuvre au travers des étapes 118 à 122 grâce à la valeur seuil tmax permet d'éviter que la mesure du courant le soit perturbée par des variations brutales de courant, ce qui pourrait conduire à un diagnostic erroné de type faux positif et à un déclenchement intempestif du disjoncteur 16.

Grâce aux étapes 110 et 112, la connaissance de l'état du véhicule 2 permet de choisir des premières valeurs seuil appropriées en fonction de l'utilisation qui est faite du véhicule 2. Par exemple, dans le fonctionnement normal du véhicule 2, du courant peut normalement être réinjecté vers la ligne 10. Au contraire, se baser sur des seuils fixes immuables empêcherait ce fonctionnement normal et conduirait à une ouverture intempestive du disjoncteur 16.

De façon optionnelle, un premier procédé de détection complémentaire peut également être mis en oeuvre conjointement au procédé décrit ci-dessus, afin d'assurer une déconnexion du dispositif de collecte 8 en cas d'anomalie qui n'aurait pas été correctement détectée à cause d'une défaillance du capteur de courant 18.

Par exemple, ce procédé est mis en oeuvre par un dispositif électronique de commande, tel qu'une deuxième unité de commande 24 du véhicule 2 similaire à l'unité de commande 20. En variante, la deuxième unité de commande 24 est omise et le procédé est mis en oeuvre par l'unité de commande 20.

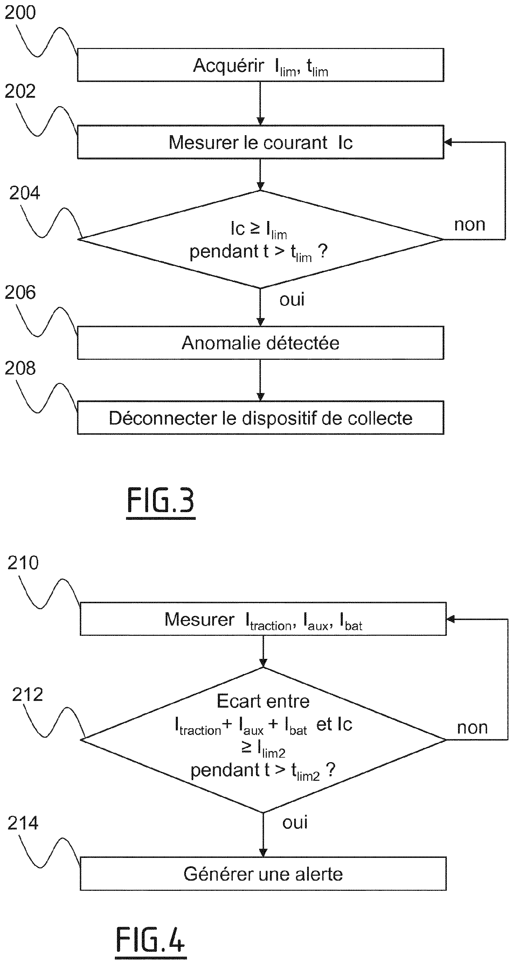

Comme illustré dans l'exemple de la figure 3, le premier procédé de détection complémentaire comporte une étape 200 d'acquisition d'une deuxième valeur seuil de courant « Iₗᵢₘ » et d'une deuxième valeur seuil de durée « tₗᵢₘ » associée à la deuxième valeur seuil de courant Iₗᵢₘ. Par exemple, ces valeurs sont acquises depuis la mémoire de l'unité de commande et sont prédéfinies par un constructeur ou un gestionnaire du véhicule 2.

Lors d'une étape 202, par exemple identique ou correspondant à l'étape 104, le courant le est mesuré par le capteur 18.

Lors d'une étape 204, la valeur du courant le mesurée est comparée à la deuxième valeur seuil de courant Iₗᵢₘ.

Si la valeur du courant le mesurée est supérieure ou égale à la deuxième valeur seuil de courant Iₗᵢₘ pendant une durée t supérieure ou égale à la deuxième valeur seuil de durée tₗᵢₘ, alors une anomalie est considérée comme étant détectée à l'étape 206 et, lors d'une étape 208, le dispositif de collecte 8 est déconnecté, par exemple de façon analogue à l'étape 116. Si ce n'est pas le cas, alors les étapes 206 et 208 ne sont pas mises en oeuvre.

Selon des variantes non illustrées, plusieurs deuxièmes valeurs seuil Iₗᵢₘ, tₗᵢₘ peuvent être définies et acquises lors de l'étape 200. Dans ce cas, il suffit que l'une des deuxièmes valeurs seuil de courant soit dépassée par le courant le pendant une durée supérieure ou égale à la deuxième valeur de seuil de durée tₗᵢₘ associée pour que les étapes 206 et 208 soient mises en oeuvre.

Selon un exemple illustratif et non limitatif, pour un véhicule ferroviaire 2 de type tramway dont le dispositif de collecte 8 est connecté à une ligne d'alimentation extérieure 10 alimentée à 750 Volts continu, les deuxièmes valeurs seuil peuvent être choisies comme suit :
- seuil de courant Iₗᵢₘ égal à 300 Ampères et seuil de durée tₗᵢₘ égal à 10 secondes pour un véhicule 2 à l'arrêt ;
- seuil de courant Iₗᵢₘ égal à 900 Ampères et seuil de durée tₗᵢₘ égal à 2 secondes pour un véhicule 2 à l'arrêt ;
- seuil de courant Iₗᵢₘ égal à 1800 Ampères et seuil de durée tₗᵢₘ égal à 40 secondes pour un véhicule 2 circulant à vitesse non nulle.

De façon optionnelle, un deuxième procédé de détection complémentaire peut également être mis en oeuvre conjointement au procédé de détection décrit ci-dessus, ou conjointement au premier procédé complémentaire, afin de détecter une anomalie de fonctionnement du capteur de courant 18. Par exemple, ce procédé est mis en oeuvre par un ordinateur central 30 du véhicule 2.

Comme illustré dans l'exemple de la figure 4, le deuxième procédé de détection complémentaire comporte une étape 210 de mesure de la valeur totale du courant I_{traction} + Iₐᵤₓ + I_{bat} qui circule dans la chaîne de traction, dans les équipements auxiliaires et à travers le dispositif de stockage 12.

Par exemple, la mesure est réalisée au moyen de capteurs de courant additionnels 32, 34, 36 qui mesurent respectivement le courant « I_{traction} » entrant ou sortant en sortie de la chaîne de traction 4, le courant « Iₐᵤₓ » entrant ou sortant en sortie des équipements auxiliaires 6, et le courant « I_{bat} » entrant ou sortant du dispositif de stockage 12.

Le calcul de la valeur totale du courant I_{traction} + Iₐᵤₓ + I_{bat} est alors réalisé par l'ordinateur 30 en additionnant les courants I_{traction}, Iₐᵤₓ et I_{bat} mesurés.

Lors d'une étape 212, l'ordinateur 30 compare la valeur de courant le mesurée avec la valeur totale, ou de préférence avec la valeur absolue de la valeur totale.

Si l'écart entre la valeur totale et la valeur de courant Ic est supérieure ou égale à une troisième valeur seuil de courant « Iₗᵢₘ₂ » pendant une durée supérieure ou égale à une troisième valeur seuil de durée « tₗᵢₘ₂ », alors l'ordinateur central 30 génère automatiquement une alerte lors d'une étape 214. Par exemple, l'alerte est générée sous la forme d'un message numérique enregistré dans un fichier de journalisation stocké dans l'ordinateur 30 et/ou d'un message numérique envoyé à destination d'un serveur informatique d'un centre de maintenance.

Selon un exemple illustratif et non limitatif, pour un véhicule ferroviaire 2 de type tramway en stationnement sous une ligne d'alimentation extérieure 10 alimentée à 750 Volts, la troisième valeur seuil de courant Iₗᵢₘ₂ est choisie égale à 50 Ampères et la troisième valeur seuil de durée tₗᵢₘ₂ est choisie égale à 1 seconde.

Les modes de réalisation et les variantes envisagés ci-dessus peuvent être combinés entre eux pour donner lieu à de nouveaux modes de réalisation.

## Revendications

1. Procédé de détection d'une défaillance dans l'alimentation électrique d'un véhicule (2), le véhicule comportant une chaîne de traction électrique (4), un dispositif de collecte (8) pour collecter un courant électrique depuis une ligne d'alimentation extérieure (10) et un dispositif de stockage d'énergie (12), le dispositif de collecte étant relié électriquement à la chaîne de traction et au dispositif de stockage d'énergie, le procédé comportant des étapes consistant à :
- mesurer (104), au moyen d'un capteur de courant (18) du véhicule, l'intensité d'un courant électrique (Ic) circulant au travers du dispositif de collecte de courant ;
- comparer (106), au moyen d'une unité de commande électronique (20) du véhicule, l'intensité mesurée avec une première valeur seuil de courant (Imax) prédéfinie ;
- si l'intensité mesurée (Ic) est supérieure ou égale à la première valeur seuil de courant (Imax), compter (110), au moyen de l'unité de commande (20), une valeur cumulée d'énergie électrique (Eacc) qui transite au travers du dispositif de collecte (8) au cours du temps ;
- comparer (112), de façon répétée, au moyen de l'unité de commande électronique, la valeur cumulée d'énergie électrique (Eacc) avec une première valeur seuil d'énergie (Emax) prédéfinie ;
- commander (116) la déconnexion électrique du dispositif de collecte (8) de la ligne d'alimentation extérieure ou de la chaîne de traction et du dispositif de stockage électrique, au moyen de l'unité de commande (20), lorsque la valeur cumulée d'énergie (Eacc) devient supérieure ou égale à la valeur seuil d'énergie (Emax), le dispositif de collecte n'étant pas déconnecté tant que la valeur cumulée d'énergie électrique reste inférieure à la première valeur seuil d'énergie ;
dans lequel la première valeur seuil de courant (Imax) et la valeur seuil d'énergie (Emax) sont choisies en fonction de caractéristiques du dispositif de collecte (8) et de la ligne d'alimentation extérieure (10) et de l'interface entre le dispositif de collecte (8) et la ligne d'alimentation extérieure (10), et notamment de leur capacité à résister à une montée en température pendant une durée donnée,
et dans lequel le procédé comporte en outre des étapes consistant à :
- acquérir (200), au moyen d'un dispositif électronique de commande (24) du véhicule, une deuxième valeur seuil de courant (Iₗᵢₘ) et une deuxième valeur seuil de durée (tₗᵢₘ) ;
- si la valeur de courant mesurée (Ic) est supérieure ou égale à la deuxième valeur seuil de courant (Iₗᵢₘ) pendant une durée (t) supérieure ou égale à la deuxième valeur seuil de durée (tₗᵢₘ), commander (208) la déconnexion électrique du dispositif de collecte (8) de la ligne d'alimentation extérieur ou de la chaîne de traction et du dispositif de stockage électrique, au moyen du dispositif de commande.

2. Procédé selon la revendication 1, **caractérisé en ce qu'**il comporte en outre une étape consistant à :
- réinitialiser (124) la valeur cumulée d'énergie électrique (Eacc), au moyen de l'unité de commande électronique (20), si la valeur d'intensité mesurée (Ic) redevient inférieure à la première valeur seuil de courant (Imax) pendant une durée (t) supérieure ou égale à une première valeur seuil de durée (tmax) prédéfinie.

3. Procédé selon l'une quelconque des revendications précédentes, **caractérisé en ce qu'**il comporte au préalable des étapes consistant à :
- détecter (100) un état de fonctionnement du véhicule (2), au moyen de l'unité de commande électronique ;
- sélectionner (102) les premières valeurs prédéfinies du seuil de courant (Imax) et du seuil d'énergie (Emax) et, le cas échéant, du seuil de durée (tmax), parmi des valeurs prédéfinies préenregistrées, la sélection étant réalisée en fonction de l'état de fonctionnement détecté.

4. Procédé selon l'une quelconque des revendications précédentes, **caractérisé en ce que** la déconnexion du dispositif de collecte est réalisée au moyen d'un disjoncteur (16) connecté en sortie du dispositif de collecte.

5. Procédé selon l'une quelconque des revendications précédentes, **caractérisé en ce qu'**il comporte en outre des étapes consistant à :
- mesurer (210), au moyen de capteurs de courant additionnels (32, 34, 36), la valeur totale du courant (I_{traction}, Iₐᵤₓ, I_{bat}) qui circule dans la chaîne de traction (4), dans des équipements auxiliaires (6) du véhicule et à travers le dispositif de stockage (12) , le dispositif de stockage, la chaîne de traction et les équipements auxiliaires étant raccordés à un circuit de distribution électrique interne (14) connecté au dispositif de collecte (8) ;
- comparer (212), au moyen d'un ordinateur central (30) du véhicule, la valeur totale du courant avec la valeur de courant mesurée (Ic) ;
- si l'écart entre la valeur totale du courant et la valeur de courant mesurée (Ic) est supérieure ou égale à une troisième valeur seuil de courant (Iₗᵢₘ₂) pendant une durée supérieure ou égale à une troisième valeur seuil de durée (tₗᵢₘ₂), générer (214) une alerte au moyen de l'ordinateur central (30).

6. Véhicule comportant une chaîne de traction électrique (4), un dispositif de collecte (8) pour collecter un courant électrique depuis une ligne d'alimentation extérieure (10), et un dispositif de stockage d'énergie (12), le dispositif de collecte étant relié électriquement à la chaîne de traction et au dispositif de stockage d'énergie, le véhicule (2) étant configuré pour mettre en oeuvre un procédé comportant des étapes consistant à :
- mesurer (104), au moyen d'un capteur de courant (18) du véhicule, l'intensité d'un courant électrique (Ic) circulant au travers du dispositif de collecte de courant ;
- comparer (106), au moyen d'une unité de commande électronique (20) du véhicule, l'intensité mesurée avec une première valeur seuil de courant (Imax) prédéfinie ;
- si l'intensité mesurée (Ic) est supérieure ou égale à la première valeur seuil de courant (Imax), compter (110), au moyen de l'unité de commande (20), une valeur cumulée d'énergie électrique (Eacc) qui transite au travers du dispositif de collecte (8) au cours du temps ;
- comparer (112), de façon répétée, au moyen de l'unité de commande électronique, la valeur cumulée d'énergie électrique (Eacc) avec une première valeur seuil d'énergie (Emax) prédéfinie ;
- commander (116) la déconnexion électrique du dispositif de collecte (8) de la ligne d'alimentation extérieure ou de la chaîne de traction et du dispositif de stockage électrique, au moyen de l'unité de commande (20), lorsque la valeur cumulée d'énergie (Eacc) devient supérieure ou égale à la valeur seuil d'énergie (Emax), le dispositif de collecte n'étant pas déconnecté tant que la valeur cumulée d'énergie électrique reste inférieure à la première valeur seuil d'énergie ;
dans lequel la première valeur seuil de courant (Imax) et la valeur seuil d'énergie (Emax) sont choisies en fonction de caractéristiques du dispositif de collecte (8) et de la ligne d'alimentation extérieure (10) et de l'interface entre le dispositif de collecte (8) et la ligne d'alimentation extérieure (10), et notamment de leur capacité à résister à une montée en température pendant une durée donnée,
et dans lequel le procédé comporte en outre des étapes consistant à :
- acquérir (200), au moyen d'un dispositif électronique de commande (24) du véhicule, une deuxième valeur seuil de courant (Iₗᵢₘ) et une deuxième valeur seuil de durée (tₗᵢₘ) ;
- si la valeur de courant mesurée (Ic) est supérieure ou égale à la deuxième valeur seuil de courant (Iₗᵢₘ) pendant une durée (t) supérieure ou égale à la deuxième valeur seuil de durée (tₗᵢₘ), commander (208) la déconnexion électrique du dispositif de collecte (8) de la ligne d'alimentation extérieur ou de la chaîne de traction et du dispositif de stockage électrique, au moyen du dispositif de commande.

## Patentansprüche

1. - Verfahren zum Erkennen eines Fehlers in der Stromversorgung eines Fahrzeugs (2), das Fahrzeug umfassend einen elektrischen Antriebsstrang (4), eine Abnehmervorrichtung (8) zum Abnehmen von elektrischem Strom von einer externen Versorgungsleitung (10) und eine Energiespeichervorrichtung (12), wobei die Abnehmervorrichtung elektrisch mit dem Antriebsstrang und der Energiespeichervorrichtung verbunden ist, das Verfahren umfassend die folgenden Schritte:
- Messen (104), mittels eines Stromsensors (18) des Fahrzeugs, der Stärke eines elektrischen Stroms (Ic), der durch die Stromabnehmervorrichtung fließt;
- Vergleichen (106), mittels einer elektronischen Steuereinheit (20) des Fahrzeugs, der gemessenen Stromstärke mit einem ersten vordefinierten Stromschwellenwert (Imax);
- wenn der gemessene Strom (Ic) größer als oder gleich wie der erste Stromschwellenwert (Imax) ist, Zählen (110), mittels der Steuereinheit (20), eines kumulierten Werts der elektrischen Energie (Eacc), die im Lauf der Zeit durch die Abnehmervorrichtung (8) fließt;
- wiederholtes Vergleichen (112), mittels der elektronischen Steuereinheit, des kumulierten Werts der elektrischen Energie (Eacc) mit einem ersten vordefinierten Energieschwellenwert (Emax);
- Steuern (116) der elektrischen Trennung der Abnehmervorrichtung (8) von der externen Versorgungsleitung oder dem Antriebsstrang und der elektrischen Speichervorrichtung mittels der Steuereinheit (20), wenn der kumulierte Energiewert (Eacc) größer als oder gleich wie der Energieschwellenwert (Emax) wird, wobei die Abnehmervorrichtung nicht getrennt wird, solange der kumulierte Wert der elektrischen Energie unter dem ersten Energieschwellenwert bleibt;
wobei der erste Stromschwellenwert (Imax) und der Energieschwellenwert (Emax) abhängig von Eigenschaften der Abnehmervorrichtung (8) und der externen Versorgungsleitung (10) und der Schnittstelle zwischen der Abnehmervorrichtung (8) und der externen Versorgungsleitung (10) gewählt werden, und insbesondere von ihrer Fähigkeit, einem Temperaturanstieg während einer gegebenen Dauer zu widerstehen,
und wobei das Verfahren ferner Schritte umfasst, die aus Folgendem bestehen:
- Erfassen (200), mittels einer elektronischen Steuervorrichtung (24) des Fahrzeugs, eines zweiten Stromschwellenwerts (Iₗᵢₘ) und eines zweiten Zeitschwellenwerts (tₗᵢₘ);
- wenn der gemessene Stromwert (Ic) über eine Zeitdauer (t), die größer als oder gleich wie der zweite Zeitdauerschwellenwert (tₗᵢₘ) ist, größer als oder gleich wie der zweite Stromschwellenwert (Iₗᵢₘ) ist, Steuern (208) der elektrischen Trennung der Abnehmervorrichtung (8) von der externen Versorgungsleitung oder dem Antriebsstrang und der elektrischen Speichervorrichtung mittels der Steuervorrichtung.

2. Verfahren gemäß Anspruch 1, **dadurch gekennzeichnet, dass** es ferner einen Schritt umfasst, der aus Folgendem besteht:
- Zurücksetzen (124) des kumulierten Werts der elektrischen Energie (Eacc) mittels der elektronischen Steuereinheit (20), wenn der gemessene Stromwert (Ic) über eine Zeitdauer (t), die größer als oder gleich wie ein erster vordefinierter Zeitdauerschwellenwert (tmax) ist, wieder unter den ersten Stromschwellenwert (Imax) fällt.

3. Verfahren nach einem der vorherigen Ansprüche, **dadurch gekennzeichnet, dass** es mindestens die Schritte umfasst, die aus Folgendem bestehen:
- Erfassen (100) eines Betriebszustands des Fahrzeugs (2) mittels der elektronischen Steuereinheit;
- Auswählen (102) der ersten vordefinierten Werte des Stromschwellenwerts (Imax) und des Energieschwellenwerts (Emax) und gegebenenfalls des Zeitdauerschwellenwerts (tmax) aus vorgespeicherten vordefinierten Werten, wobei die Auswahl abhängig von dem erfassten Betriebszustand erfolgt.

4. Verfahren nach einem der vorherigen Ansprüche, **dadurch gekennzeichnet, dass** die Trennung der Abnehmervorrichtung mittels eines Unterbrechers (16) erfolgt, der mit dem Ausgang der Abnehmervorrichtung verbunden ist.

5. Verfahren nach einem der vorherigen Ansprüche, **dadurch gekennzeichnet, dass** es ferner die Schritte umfasst, die aus Folgendem bestehen:
- Messen (210), mittels zusätzlicher Stromsensoren (32, 34, 36), des Gesamtwerts des Stroms (I_{traction}, Iₐᵤₓ, I_{bat}), der in dem Antriebsstrang (4), in Zusatzausrüstung (6) des Fahrzeugs und durch die Speichervorrichtung (12) fließt, wobei die Speichervorrichtung, der Antriebsstrang und die Zusatzausrüstung an einen internen elektrischen Verteilerkreis (14) angeschlossen sind, der mit der Abnehmervorrichtung (8) verbunden ist;
- Vergleichen (212), mittels eines zentralen Rechners (30) des Fahrzeugs, des Gesamtstromwerts mit dem gemessenen Stromwert (Ic);
- wenn die Abweichung zwischen dem Gesamtstromwert und dem gemessenen Stromwert (Ic) über eine Zeitdauer, die größer als oder gleich wie ein dritter Zeitdauerschwellenwert (tₗᵢₘ₂) ist, größer als oder gleich wie ein dritter Stromschwellenwert (Iₗᵢₘ₂) ist, Erzeugen (214) einer Warnung mittels des zentralen Rechners (30).

6. Fahrzeug, umfassend einen elektrischen Antriebsstrang (4), eine Abnehmervorrichtung (8) zum Abnehmen von elektrischem Strom von einer externen Versorgungsleitung (10) und eine Energiespeichervorrichtung (12), wobei die Abnehmervorrichtung elektrisch mit dem Antriebsstrang und der Energiespeichervorrichtung verbunden ist, wobei das Fahrzeug (2) konfiguriert ist, um ein Verfahren zu implementieren, umfassend Schritte, die aus Folgendem bestehen:
- Messen (104), mittels eines Stromsensors (18) des Fahrzeugs, der Stärke eines elektrischen Stroms (Ic), der durch die Stromabnehmervorrichtung fließt;
- Vergleichen (106), mittels einer elektronischen Steuereinheit (20) des Fahrzeugs, der gemessenen Stromstärke mit einem ersten vordefinierten Stromschwellenwert (Imax);
- wenn der gemessene Strom (Ic) größer als oder gleich wie der erste Stromschwellenwert (Imax) ist, Zählen (110), mittels der Steuereinheit (20), eines kumulierten Werts der elektrischen Energie (Eacc), die im Lauf der Zeit durch die Abnehmervorrichtung (8) fließt;
- wiederholtes Vergleichen (112), mittels der elektronischen Steuereinheit, des kumulierten Werts der elektrischen Energie (Eacc) mit einem ersten vordefinierten Energieschwellenwert (Emax);
- Steuern (116) der elektrischen Trennung der Abnehmervorrichtung (8) von der externen Versorgungsleitung oder dem Antriebsstrang und der elektrischen Speichervorrichtung mittels der Steuereinheit (20), wenn der kumulierte Energiewert (Eacc) größer als oder gleich wie der Energieschwellenwert (Emax) wird, wobei die Abnehmervorrichtung nicht getrennt wird, solange der kumulierte Wert der elektrischen Energie unter dem ersten Energieschwellenwert bleibt;
wobei der erste Stromschwellenwert (Imax) und der Energieschwellenwert (Emax) abhängig von Eigenschaften der Abnehmervorrichtung (8) und der externen Versorgungsleitung (10) und der Schnittstelle zwischen der Abnehmervorrichtung (8) und der externen Versorgungsleitung (10) gewählt werden, und insbesondere von ihrer Fähigkeit, einem Temperaturanstieg während einer gegebenen Dauer zu widerstehen,
und wobei das Verfahren ferner Schritte umfasst, die aus Folgendem bestehen:
- Erfassen (200), mittels einer elektronischen Steuervorrichtung (24) des Fahrzeugs, eines zweiten Stromschwellenwerts (Iₗᵢₘ) und eines zweiten Zeitschwellenwerts (tₗᵢₘ);
- wenn der gemessene Stromwert (Ic) über eine Zeitdauer (t), die größer als oder gleich wie der zweite Zeitdauerschwellenwert (tₗᵢₘ) ist, größer als oder gleich wie der zweite Stromschwellenwert (Iₗᵢₘ) ist, Steuern (208) der elektrischen Trennung der Abnehmervorrichtung (8) von der externen Versorgungsleitung oder dem Antriebsstrang und der elektrischen Speichervorrichtung mittels der Steuervorrichtung.

## Claims

1. -A method for detecting a fault in the electric power supply of a vehicle (2), the vehicle comprising an electrical power train (4), a collection device (8) for collecting electrical current from an external supply line (10) and an energy storage device (12), the collection device being electrically connected to the power train and to the energy storage device, the method comprising the steps of:
- measuring (104), by means of a current sensor (18) of the vehicle, the intensity of an electric current (Ic) flowing through the current collection device;
- comparing (106) the measured current, by means of an electronic control unit (20) of the vehicle, with a first predefined current threshold value (Imax);
- if the measured current (Ic) is greater than or equal to the first current threshold value (Imax), counting (110), by means of the control unit (20), an accumulated value of electrical energy (Eacc) that transits through the collection device (8) over time;
- comparing (112), repeatedly, by means of the electronic control unit, the accumulated electrical energy value (Eacc) with a first predefined energy threshold value (Emax);
- controlling (116) the electrical disconnection of the collection device (8) from the external supply line or the power train and the electrical storage device, by means of the control unit (20), when the cumulative energy value (Eacc) becomes greater than or equal to the first energy threshold value (Emax), the collection device not being disconnected as long as the cumulative electrical energy value remains less than the first energy threshold value;
wherein the first current threshold value (Imax) and the energy threshold value (Emax) are selected as a function of characteristics of the collection device (8) and the external supply line (10) and of the interface between the collection device (8) and the external supply line (10), and in particular of their ability to withstand a temperature rise for a given period of time,
and wherein the method further comprises the steps consisting of:
- acquiring (200), by means of an electronic command device (24) of the vehicle, a second current threshold value (Iₗᵢₘ) and a second time threshold value (tₗᵢₘ);
- if the measured current value (Ic) is greater than or equal to the second current threshold value (Iₗᵢₘ) for a period of time (t) greater than or equal to the second time threshold value (tₗᵢₘ), commanding (208) the electrical disconnection of the collection device (8) from the external power supply line or the power train and the electrical storage device, by means of the command device.

2. - The method according to claim 1, **characterised in that** it further comprises a step consisting of:
- resetting (124) the accumulated electrical energy value (Eacc), by means of the electronic control unit (20), if the measured current value (Ic) falls below the first current threshold value (Imax) again for a period of time (t) greater than or equal to a predefined first duration threshold value (tmax).

3. - The method according to any one of the preceding claims, **characterised in that** it previously comprises, steps consisting of:
- detecting (100) an operating state of the vehicle (2), by means of the electronic control unit;
- selecting (102) the first predefined values of the current threshold (Imax) and the energy threshold (Emax) and, if applicable, the time threshold (tmax) from predefined, prestored values, the selection being carried out as a function of the detected operating state.

4. - The method according to any of the preceding claims, **characterised in that** disconnection of the collection device is achieved by means of a circuit breaker (16) connected to the output of the collection device.

5. - The method according to any one of the preceding claims, **characterised in that** it further comprises steps consisting of:
- measuring (210), by means of additional current sensors (32, 34, 36), the total value of the current (I_{traction}, Iₐᵤₓ, I_{bat}) flowing through the power train (4), through auxiliary equipment (6) of the vehicle and through the storage device (12), the storage device, the power train and the auxiliary equipment being connected to an internal electrical distribution circuit (14) connected to the collection device (8);
- comparing (212), by means of a central computer (30) of the vehicle, the total current value with the measured current value (Ic);
- if the deviation between the total current value and the measured current value (Ic) is greater than or equal to a third current threshold value (Iₗᵢₘ₂) for a period of time greater than or equal to a third time threshold value (tₗᵢₘ₂), generating (214) an alert by means of the central computer (30).

6. -The vehicle comprising an electric power train (4), a collection device (8) for collecting electric current from an external power line (10), and an energy storage device (12), the collection device being electrically connected to the power train and the energy storage device, the vehicle (2) being configured to implement a method comprising the steps of:
- measuring (104), by means of a current sensor (18) of the vehicle, the intensity of an electric current (Ic) flowing through the current collection device;
- comparing (106) the measured current, by means of an electronic control unit (20) of the vehicle, with a first predefined current threshold value (Imax);
- if the measured current (Ic) is greater than or equal to the first current threshold value (Imax), counting (110), by means of the control unit (20), an accumulated value of electrical energy (Eacc) that transits through the collection device (8) over time;
- comparing (112), repeatedly, by means of the electronic control unit, the accumulated electrical energy value (Eacc) with a first predefined energy threshold value (Emax);
- controlling (116) the electrical disconnection of the collection device (8) from the external supply line or the power train and the electrical storage device, by means of the control unit (20), when the accumulated energy value (Eacc) becomes greater than or equal to the first energy threshold value (Emax), the collection device not being disconnected as long as the cumulative electrical energy value remains less than the first energy threshold value;
wherein the first current threshold value (Imax) and the energy threshold value (Emax) are selected as a function of characteristics of the collection device (8) and the external supply line (10) and of the interface between the collection device (8) and the external supply line (10), and in particular of their ability to withstand a temperature rise for a given period of time,
and wherein the method further comprises the steps consisting of:
- acquiring (200), by means of an electronic command device (24) of the vehicle, a second current threshold value (Iₗᵢₘ) and a second time threshold value (tₗᵢₘ);
- if the measured current value (Ic) is greater than or equal to the second current threshold value (Iₗᵢₘ) for a period of time (t) greater than or equal to the second time threshold value (tₗᵢₘ), commanding (208) the electrical disconnection of the collection device (8) from the external power supply line or the power train and the electrical storage device, by means of the command device.
